Europäisches Patentamt

European Patent Office

Office européen des brevets

(11) Numéro de publication: **0 293 279 B1**

# FASCICULE DE BREVET EUROPEEN

(45) Date de publication de fascicule du brevet: **15.04.92** (51) Int. Cl.⁵: **H03L 1/02**

(21) Numéro de dépôt: **88401086.9**

(22) Date de dépôt: **04.05.88**

(54) **Oscillateur à résonateur piézoélectrique compensé en température, à haute pureté spectrale, et commandable en fréquence.**

(30) Priorité: **22.05.87 FR 8707207**

(43) Date de publication de la demande:
**30.11.88 Bulletin 88/48**

(45) Mention de la délivrance du brevet:
**15.04.92 Bulletin 92/16**

(84) Etats contractants désignés:
**AT BE CH DE GB IT LI LU NL SE**

(56) Documents cités:
**DE-A- 2 936 378
GB-A- 2 038 125
US-A- 3 831 111**

**PATENT ABSTRACTS OF JAPAN, vol. 9, no. 248 (E-347)[1971], 4 octobre 1985, page 74 E 347; & JP-A-60 97 702 (KINSEKI K.K.) 31-05-1985**

**TOUTE L'ELECTRONIOUE, no. 450, janvier 1980, pages 13-26, Paris, FR; G. MOURIER: "Les oscillateurs "pilotes" modulaires"**

**IEEE TRANSACTIONS ON INSTRUMENTA-TION AND MEASUREMENT, vol. IM-28, no. 3, septembre 1979, pages 188-193, IEEE, New**

**York, US; J. VANIER et al.: "Transfer of frequency stability from an atomic frequency reference to a quartz-crystal oscillator"**

**W. P. Robins "Phase Noise in Signal Sources", IEE Telecommunications series 9, Peter Peregrinus Ltd, London, UK, 1984, ISBN 086341 026 X.**

(73) Titulaire: **COMPAGNIE D'ELECTRONIOUE ET DE PIEZO-ELECTRICITE - C.E.P.E.
44, avenue de la Glacière
F-95100 Argenteuil(FR)**

(72) Inventeur: **Parly, Didier
THOMSON-CSF SCPI 19, avenue de Messine
F-75008 Paris(FR)**
Inventeur: **Robichon, Gilles
THOMSON-CSF SCPI 19, avenue de Messine
F-75008 Paris(FR)**

(74) Mandataire: **Guérin, Michel et al
THOMSON-CSF SCPI
F-92045 PARIS LA DEFENSE CEDEX 67(FR)**

## Description

La présente invention se rapporte aux oscillateurs à résonateur piézoélectrique, compensés en température, à haute pureté spectrale et commandables en fréquence.

Les oscillateurs à résonateur piézoélectrique compensés en température et commandables en fréquence de type connu sont constitués d'un réseau de compensation en température, d'un circuit de traitement dont une première entrée recueille le signal issu du réseau de compensation en température et dont une seconde entrée recueille un signal de commande en fréquence, d'un circuit déphaseur pour la commande en fréquence comprenant le résonateur piézo électrique, suivi d'un circuit oscillateur.

Un oscillateur à résonateur piézoélectrique de ce type est décrit dans la demande GB-A-2 038 125.

On connait aussi par le brevet JP-A-60 97702 un oscillateur à résonateur piézoélectrique comportant un réseau de compensation numérique. Un filtre RC est inséré entre le réseau de compensation et le circuit de traitement pour limiter l'excursion en fréquence lors d'un saut de la tension de compensation.

L'ouvrage de WP ROBINS "Phase noise un signal sources " P. Peregrinus LTD traite notamment dans son chapitre 5, du bruit affectant la fréquence des près de la porteuse. Ce chapitre traite de l'influence du bruit pratiquement inévitable dans les circuits électroniques.

La stabilité en fréquence d'un oscillateur à résonateur piézoélectrique est un paramètre très important. Dans le domaine des radiocommunications, les bases de temps doivent être aussi précises que possible, aussi bien à long terme qu'à court terme. Cela signifie que la fréquence en sortie de l'oscillateur doit varier aussi peu que possible.

De façon idéale, une tension sinusoïdale s'écrit :

$$V(t) = Vo \sin 2 \pi fo \, t$$

où
Vo est l'amplitude de la tension
fo est la fréquence.
Mais pratiquement cette tension devient

$$V(t) = (Vo + \epsilon (t)) \sin (2 \pi fo \, t + \Delta (t))$$

à cause de parasites.

$\epsilon(t)$ représente la variation d'amplitude

$\Delta(t)$ représente la variation de phase ou bruit de phase.

La phase et la fréquence étant liées, la stabilité en fréquence et le bruit de phase sont également liés.

Le bruit de phase peut se mesurer en utilisant un analyseur de spectre basse fréquence dans la méthode dite d'asservissement de phase d'un oscillateur de référence sur l'oscillateur à tester. Ce bruit de phase décroît quand la fréquence par rapport à la porteuse augmente.

Un oscillateur à haute pureté spectrale aura donc près de la porteuse un bruit de phase aussi faible que possible.

Dans un oscillateur à résonateur piézoélectrique les paramètres entraînant des variations de fréquence sont nombreux : température, vibrations, chocs, accélération, pression, etc. Parmi toutes ces causes les effets de la températures induisent une variation de fréquence importante.

Le spectre du bruit d'origine thermique se retrouve pour une par non négligeable dans le spectre du bruit de phase à basse fréquence.

La présente invention vise à remédier à cet inconvénient en proposant un oscillateur à résonateur piézoélectrique comportant en sortie du réseau de compensation des moyens de filtrage permettant de retirer le bruit d'origine thermique.

Plus précisément l'invention concerne un oscillateur à résonateur piézoélectrique selon la revendication 1.

L'invention sera mieux comprise à l'aide de la description et des figures suivantes:
- la figure 1 représente le schéma d'un oscillateur selon l'invention ;
- la figure 2 donne une représentation du bruit de phase en fonction de la fréquence pour un oscillateur de l'art antérieur ;
- la figure 3 donne une représentation du bruit de phase en fonction de la fréquence pour un oscillateur selon l'invention.

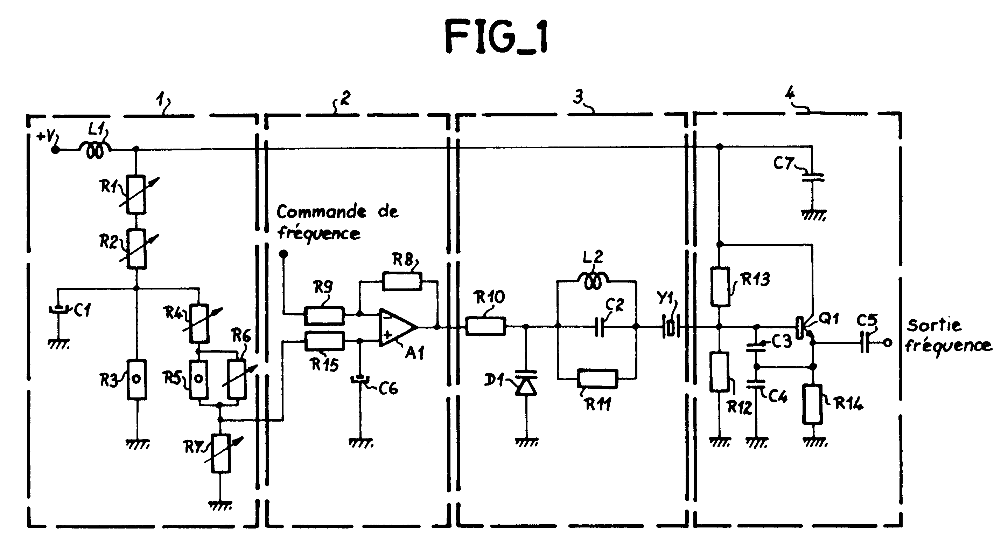

La figure 1 représente le schéma complet d'un oscillateur selon l'invention.

Ce schéma peut se décomposer en quatre parties. Une première partie est un réseau de compensation 1 de type connu. Il est composé de thermistances R3, R5, de résistances R1, R2, R4, R6, R7 et de la capacité C1. Ce réseau de compensation 1 thermosensible permet de réduire tout écart de fréquence en présence d'une variation de température. Les résistances R1, R2, R4, R6, R7 sont ajustables manuellement pour obtenir un minimum de variation de fréquence en sortie, à une température donnée.

Le réglage se fait en fonction de la tension d'alimentation +V prévue pour la gamme de température considérée. Cette tension d'alimentation est filtrée par la self L1 et la capacité C7.

Une deuxième partie est un circuit de traitement 2. Il est composé d'un amplificateur opérationnel à entrées différentielles A1 monté en sous-

2

tracteur. L'entrée avec inversion est attaquée à travers une résistance R9 par une tension de commande de fréquence. Une résistance R8 assure la contre-réaction. L'entrée sans inversion est attaquée par la tension de sortie du réseau de compensation à travers un filtre. Ce filtre est dans le cas de la figure 1 un filtre passe-bas composé d'une résistance R15 et d'une capacité C6. Ce filtre passe-bas permet de supprimer l'influence du bruit d'origine thermique provenant des thermistances, à basse fréquence.

Ce traitement est d'autant plus efficace que la fréquence de coupure du filtre passe-bas est basse. Diverses mesures ont montré que l'influence du filtrage commence à se faire sentir pour des fréquences de coupure de l'ordre de 5 Hz.

Une troisième partie est un circuit déphaseur 3 constitué d'une diode D1 à capacité variable dite varicap, polarisée à travers une résistance R10 par la tension continue en sortie de l'amplificateur A1. Cette tension permet la commande en fréquence.

La tension aux bornes de cette diode D1 est appliquée à un circuit parallèle oscillant composé d'une inductance L2, d'une capacité C2 et d'une résistance R11. Un résonateur piézoélectrique Y1 est mis en série avec le circuit parallèle R11, L2, C2.

Le circuit oscillant L2, C2, R11 et le résonateur piézoélectrique Y1 délivrent la fréquence pilote. Une quatrième partie est un circuit oscillateur de type Clapp, par exemple, en série avec le résonateur Y1. Ce circuit oscillateur 4 comprend un transistor Q1 dont la base est polarisée par un pont de résistances R12, R13.

Un pont capacitif C1, C3 relie la base du transistor O1 à la masse. Le point milieu de ce pont capacitif est relié à l'émetteur du transistor O1.

La sortie du circuit oscillateur se fait sur une résistance R14 à travers une capacité de liaison C5.

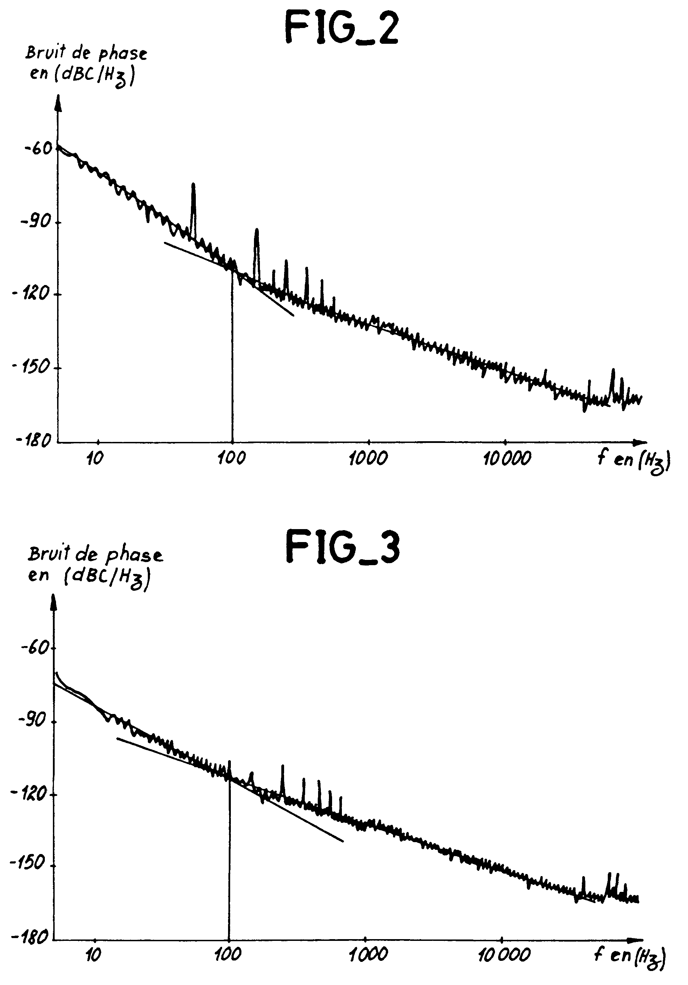

La figure 2 représente la variation du bruit de phase en fonction de la fréquence, d'un oscillateur à résonateur piézoélectrique selon l'art antérieur sans circuit de filtrage. Le bruit de phase est représenté sur une échelle logarithmique et est exprimé en dBc/Hz c'est-à-dire en décibel sous porteuse par Hertz. Cette représentation du bruit de phase a été effectuée par la méthode dite par asservissement de phase d'un oscillateur de référence sur l'oscillateur à tester. Sur cette représentation, entre 0 et 100Hz le bruit de phase décroît rapidement. Dans cette plage de fréquences, la pente de la courbe est de -40 décibels par décade ou d'ordre $f^{-4}$. Au delà de 100 Hz la pente de la courbe n'est plus que de -20 décibels par décade.

La figure 3 représente de la même façon le bruit de phase en fonction de la fréquence d'un oscillateur à résonateur piézoélectrique selon l'invention avec le circuit de filtrage. Entre 0 et 100Hz le bruit de phase est beaucoup plus faible que sur l'exemple précédent. La pente de la courbe n'est plus que de -30 décibels par décade. Il n'y a pas de changement pour des fréquences supérieures à 100Hz. Le bruit d'origine thermique provenant du réseau de compensation a été supprimé dans le bruit de phase.

Le circuit de filtrage permet d'obtenir entre 0 et 100Hz un gain appréciable. A 10Hz par exemple le gain est de 12 décibels. Ces résultats sont obtenus avec un filtre passe-bas constitue par exemple d'une résistance R15 = 10kΩ et d'une capacité C6 = 22 μF. La fréquence de coupure correspondante est de 0,7Hz.

**Revendications**

1. Oscillateur à résonateur piézoélectrique compensé en température comportant :
   - un réseau de compensation (1) en température analogique avec thermistances,
   - un circuit de traitement (2) dont une première entrée recueille le signal issu du réseau de compensation en température et dont une seconde entrée recueille un signal de commande en fréquence,
   - un circuit déphaseur (3) pour la commande en fréquence comprenant le résonateur, dont l'entrée est reliée à la sortie du circuit de traitement et dont la sortie est reliée à un circuit oscillateur (4) de façon à agir sur la fréquence de résonance du circuit oscillateur,
   caractérisé en ce qu'en vue de supprimer, dans le bruit de phase de l'oscillateur, le bruit d'origine thermique lié aux fluctuations de température et provenant du réseau de compensation, un filtre passe-bas de type RC ayant une fréquence de coupure inférieure à 5Hz est inséré entre la sortie du réseau de compensation et la première entrée du circuit de traitement.

2. Oscillateur selon la revendication 1, caractérisé en ce que le réseau de compensation comporte aussi des résistances.

3. Oscillateur selon l'une des revendications 1 ou 2, caractérisé en ce que le circuit déphaseur comprend une diode varicap.

4. Oscillateur selon l'une des revendications 1 à 3, caractérisé en ce que le circuit oscillateur est de type Clapp.

## Claims

1. An oscillator of the temperature compensated piezoelectric resonator type, comprising:
   - an analog temperature compensating network (1) with thermistors,
   - a treatment circuit (2) of which a first input gets the signal from the temperature compensating network and of which a second input gets a frequency control signal,
   - a phase modifying circuit (3) for frequency control comprising the resonator, of which the input is connected with the output of the treatment circuit and of which the output is connected with an oscillating circuit (4) in such a manner as to act on the resonance frequency of the oscillator circuit,
   characterized in that in order to suppress, in the phase noise of the oscillator, the noise of thermic origin linked with the temperature fluctuations and coming from the compensating network, a low pass filter of the RC type having a cut off frequency of under 5 Hz is placed between the output of the compensation network and the first input of the treatment circuit.

2. The oscillator as claimed in claim 1, characterized in that the compensation network also comprises resistors.

3. The oscillator as claimed in claim 1 or claim 2, characterized in that the phase modifying circuit comprises a varicap diode.

4. The oscillator as claimed in any one of the preceding claims 1 through 3, characterized in that the oscillator circuit is of the Clapp type.

## Patentansprüche

1. Temperaturkompensierter Oszillator mit piezoelektrischem Resonator, mit:
   - einem analogen Temperatur-Kompensationsnetzwerk (1) mit Thermistoren,
   - einer Verarbeitungsschaltung (2), von der ein erster Eingang das vom Temperatur-Kompensationsnetzwerk ausgegebene Signal empfängt und von der ein zweiter Eingang ein Frequenzsteuersignal empfängt,
   - einer Phasenschieberschaltung (3) für die Steuerung der Frequenz, die den Resonator umfaßt und deren Eingang mit dem Ausgang der Verarbeitungsschaltung verbunden ist und deren Ausgang mit einer Oszillatorschaltung (4) verbunden ist, derart, daß auf die Resonanzfrequenz der Oszillatorschaltung eingewirkt wird,
   dadurch gekennzeichnet, daß für die Unterdrückung des mit den Temperaturschwankungen verknüpften und aus dem Kompensationsnetzwerk hervorgehenden ursprünglichen thermischen Rauschens im Phasenrauschen des Oszillators zwischen den Ausgang des Kompensationsnetzwerks und den ersten Eingang der Verarbeitungsschaltung ein Tiefpaßfilter vom RC-Typ mit einer Grenzfrequenz unterhalb von 5 Hz eingesetzt ist.

2. Oszillator gemäß Anspruch 1, dadurch gekennzeichnet, daß das Kompensationsnetzwerk außerdem Widerstände umfaßt.

3. Oszillator gemäß einem der Ansprüche 1 oder 2, dadurch gekennzeichnet, daß die Phasenschieberschaltung eine VaricapDiode umfaßt.

4. Oszillator gemäß einem der Ansprüche 1 bis 3, dadurch gekennzeichnet, daß die Oszillatorschaltung vom Clapp-Typ ist.

# FIG_1

Commande de fréquence

Sortie fréquence

EP 0 293 279 B1

# FIG_2

Bruit de phase en (dBC/Hz)

-60
-90
-120
-150
-180

10   100   1000   10 000   f en (Hz)

# FIG_3

Bruit de phase en (dBC/Hz)

-60
-90
-120
-150
-180

10   100   1000   10 000   f en (Hz)

6